# EUROPEAN PATENT APPLICATION

(11) **EP 2 315 215 A1**
(43) Date of publication of application: **27.04.2011**
(21) Application number: 09806608.7
(22) Date of filing: 26.06.2009
(51) Int. Cl.: H01B 1/22, C09J 163/00, C09J 201/00, H01B 1/00, H01L 21/52, H05K 3/32

(54) **CONDUCTIVE ADHESIVE AND LED SUBSTRATE USING THE SAME**

(30) Priority: 13.08.2008 JP 2008208746
(71) Applicant: Sumitomo Electric Industries, Ltd., Chuo-ku Osaka-shi Osaka 541-0041 (JP)
(72) Inventor: OKADA, Issei, Osaka-shi Osaka 554-0024 (JP); SHIMODA, Kouhei, Osaka-shi Osaka 554-0024 (JP)
(74) Representative: Cross, Rupert Edward Blount
(86) International application number: PCT/JP2009/061703
(87) International publication number: WO 2010/018712

(57) **Abstract**

Provided are a conductive adhesive capable of ensuring both conductive properties and adhesion properties and an LED substrate using the conductive adhesive. The conductive adhesive contains a conductive filler, a binder resin, and a solvent as main components thereof, and the conductive filler contains a metal powder having an average particle size of 2 to 30 µm as a main component thereof and contains ultrafine metal particles having an average particle size of 100 nm or less.

## Description

### Technical Field

The present invention relates to conductive adhesives used for bonding, for example, semiconductor devices and chip parts and also relates to LED substrates produced using the conductive adhesives.

### Background Art

The recent trend towards more compact, more functional electronic devices has led to the miniaturization of component parts (for example, semiconductor devices such as LED devices and chip parts such as chip resistors). Accordingly, in the field of electronics packaging, conductive adhesives have been widely used as adhesives with which, for example, semiconductor devices can be easily bonded to metal substrates.

A typically used conductive adhesive contains a conductive filler, a binder resin, and a solvent as its main components. More specifically, for example, a conductive adhesive is disclosed that contains, as its main components, a conductive filler formed of a conductive metal powder such as silver, gold, copper, or carbon powder, a binder resin containing an epoxy resin as its main component, and a solvent having compatibility with the epoxy resin. The content of the conductive filler in the conductive adhesive is set to 70% to 90% by mass of the total amount of composition, and the epoxy resin used is a combination of an epoxy resin that is liquid at room temperature and an epoxy resin that has an average molecular weight of 500 to 10,000 and that is solid at room temperature. In this case, it is disclosed that a conductive adhesive having a stress relaxation effect on a flexible printed circuit board and having superior conductive properties and adhesion properties can be provided (see, for example, Patent Document 1).
[Patent Document 1] Japanese Unexamined Patent Application Publication No. 2007-277384

### Disclosure of Invention

### Problems to be Solved by the Invention

Although conductive adhesives require both high conductive properties and high adhesion properties, it is generally difficult to ensure both conductive properties and adhesion properties. That is, the conductive adhesive disclosed in Patent Document 1 above has a problem in that an increase in the proportion of the conductive filler in the conductive adhesive improves the conductive properties but degrades the adhesion properties as a result of the decrease in the proportion of the binder resin, and also has a problem in that an increase in the proportion of the binder resin in the conductive adhesive improves the adhesion properties but degrades the conductive properties as a result of the decrease in the proportion of the conductive filler.

Accordingly, an object of the present invention, which has been made in light of the problem described above, is to provide a conductive adhesive capable of ensuring both conductive properties and adhesion properties.

### Means for Solving the Problems

To achieve the above object, according to a first invention of the present application, a conductive adhesive contains a conductive filler, a binder resin, and a solvent as main components thereof, and the conductive filler contains a metal powder having an average particle size of 2 to 30 µm as a main component thereof and contains ultrafine metal particles having an average particle size of 100 nm or less.

In this case, the ultrafine metal particles having a particle size of 100 nm or less fill gaps in the metal powder used as the conductive filler and having relatively large particle size to increase the packing density of the metal in the conductive filler, thus improving the conductive properties at low sintering temperature (200°C or less). In addition, the ultrafine metal particles having an average particle size of 100 nm or less sinter at low temperature (200°C or less) to form a metallic bond with the metal substrate to be bonded. Thus, the adhesion properties of the conductive adhesive can be improved.

According to a second invention of the present application, in the conductive adhesive of the first invention of the present application, the content of the ultrafine metal particles in the overall conductive filler is 0.1 % to 10% by mass.

In this case, the ultrafine metal particles sufficiently provide the effect of improving the conductive properties and the adhesion properties without a substantial cost increase.
According to a third invention of the present application, in the conductive adhesive of the first or second invention of the present application, the content of the conductive filler in the overall conductive adhesive is 50% to 90% by mass. In this case, the conductive properties and adhesion properties of the conductive adhesive can be reliably improved.

According to a fourth invention of the present application, in the conductive adhesive of one of the first to third inventions of the present application, the metal powder is silver powder. In this case, because silver powder has low specific resistance, a conductive adhesive having superior conductive properties can be provided. In addition, a low-cost, oxidation-resistant conductive adhesive can be provided.

In addition, the conductive adhesive of one of the first to fourth inventions of the present application has the superior property of providing improved conductive properties and adhesion properties. Thus, according to a fifth invention of the present application, the conductive adhesive of one of the first to fourth inventions of the present application is suitable for an LED substrate including a metal substrate and an LED device, and the metal substrate and the LED device are bonded with the conductive adhesive of one of the first to fourth inventions of the present application.

### Advantages

The present invention provides a conductive adhesive capable of ensuring both conductive properties and adhesion properties and an LED substrate using the conductive adhesive.

### Best Modes for Carrying Out the Invention

A preferred embodiment of the present invention will now be described. A conductive adhesive of the present invention is prepared in paste form by dispersing a conductive filler such as a metal powder in a binder resin and is used for bonding component parts (for example, semiconductor devices such as LED devices and chip parts such as chip resistors) to metal substrates.

The metal powder used as the conductive filler may be a metal powder such as silver powder, copper powder, platinum powder, gold powder, nickel powder, or palladium powder or a carbon powder such as carbon black or graphite powder. Of these, silver powder is preferably used. This is because silver powder has superior conductive properties with low specific resistance, is resistant to oxidation, and is inexpensive.

The metal powder used in the present invention is a squamiform metal powder. The squamiform metal powder may be a flake-shaped (squamiform) metal powder prepared such that, of the dimensions of the squamiform metal powder in three perpendicular directions (length, width, and thickness directions), the dimension in one direction (thickness direction) is about one half or less, particularly, one fiftieth to one fifth, in contrast of the maximum dimension in the other two directions (length and width directions), and such that the average particle size is 2 to 30 µm. If the average particle size falls below 2 µm, the conductive properties may be degraded because the squamiform metal powder does not provide the effect of reducing contact resistance. On the other hand, if the average particle size exceeds 30 µm, for example, when the conductive adhesive is used for screen printing, the squamiform metal powder may clog a screen mask having a mesh with small aperture diameter, thus causing printing defects such as thin spots and discontinuities. The term "average particle size" as used herein refers to the 50% particle size (D₅₀), which can be measured using, for example, a particle size distribution measuring instrument depending on the laser Doppler method (the Microtrac (registered trademark) particle size distribution measuring instrument MT3000II, manufactured by Nikkiso Co., Ltd.).

In the above range, particularly, the average particle size of the squamiform metal powder is preferably 3 to 20 µm in view of reducing the contact resistance for improved conductive properties and preventing, for example, clogging of a screen mask for prevention of printing defects such as thin spots and discontinuities. Squamiform metal powders produced by various known methods such as the liquid-phase reduction method and the vapor growth method can be used.

In addition, the content of the conductive filler in the overall conductive adhesive is preferably 50% to 90% by mass in view of ensuring both conductive properties and adhesion properties. If the content of the conductive filler falls below 50% by mass, the adhesion properties are improved, but the conductive properties may be degraded. On the other hand, if the content of the conductive filler exceeds 90% by mass, the conductive properties are improved, but the adhesion properties may be degraded.

The binder resin used is an organic insulating resin, and the organic insulating resin is preferably a heat-resistant resin because it remains in a conductive film after heat treatment. Examples of such heat-resistant resins include fluorine resins, polyimide resins, polyamide-imide resins, polyester-imide resins, polyester resins, polyether sulfone resins, polyether ketone resins, polyether ether ketone resins, polybenzimidazole resins, polybenzoxazole resins, polyphenylene sulfide resins, bismaleimide resins, epoxy resins, phenol resins, and phenoxy resins. These heat-resistant resins can be used as the binder resin alone or in a combination of two or more.

Of these resins, epoxy resins are preferably used in view of improving the heat resistance of the conductive adhesive. Examples of epoxy resins include, but are not limited to, bisphenol-type epoxy resins such as bisphenol A, F, S, and AD-type epoxy resins, naphthalene-type epoxy resins, novolac-type epoxy resins, biphenyl-type epoxy resins, and dicyclopentadiene-type epoxy resins. Phenoxy-type epoxy resins, which are high-molecular-weight epoxy resins, can also be used.

In addition, the content of the binder resin in the overall conductive adhesive is preferably 8% to 40% by mass. If the content of the binder resin falls below 8% by mass, the adhesion properties may be degraded. On the other hand, if the content of the binder resin exceeds 40% by mass, the conductive properties may be degraded.

In addition to the components described above, the conductive adhesive of the present invention may further contain, for example, a latent curing agent for curing the binder resin, a solvent, and other additives. Examples of latent curing agents for epoxy resins include imidazole-type latent curing agents, hydrazide-type latent curing agents, amine-type latent curing agents such as boron-trifluoride-amine complexes, amine imides, polyamines, tertiary amines, and alkyl ureas, dicyandiamide-type latent curing agents, acid anhydride-type latent curing agents, phenol-type latent curing agents, and modified materials thereof, and they can be used alone or as a mixture of two or more.

Of these latent curing agents, an imidazole-type latent curing agent is preferably used in view of superior storage stability at low temperature and fast curing. The imidazole-type latent curing agent used may be a known imidazole-type latent curing agent. More specifically, an example is an adduct of an imidazole compound with an epoxy resin. Examples of imidazole compounds include imidazole, 2-methylimidazole, 2-ethylimidazole, 2-propylimidazole, 2-dodecylimidazole, 2-phenylimidazole, 2-phenyl-4-methylimidazole, and 4-methylimidazole.

In particular, the latent curing agent is preferably microcapsulated in a polymer substance such as polyurethane or polyester or an inorganic substance such as a metallic thin-film, such as of nickel or copper, or calcium silicate to ensure both long-term storage stability and fast curing, which are mutually contradictory properties. Thus, a microcapsulated imidazole-type latent curing agent is particularly preferred.

The conductive adhesive preferably cures in the temperature range of 200°C or less because it is used in combination with, for example, a substrate formed of a versatile material with low heat resistance; therefore, it is preferable to appropriately select and use a curing agent capable of inducing the curing reaction of the binder resin at a predetermined temperature in the range of 200°C or less. The curing agent may be added in an amount equal to the theoretical equivalent of the binder resin.

In addition, the content of the latent curing agent in the overall conductive adhesive is preferably 0.2% to 5% by mass. If the content of the latent curing agent falls below 0.2% by mass, the adhesion properties may be insufficient because the epoxy resin cures insufficiently. On the other hand, if the content of the latent curing agent exceeds 5% by mass, the stability may be decreased because the curing agent reacts during storage.

In addition, the solvent for dissolving the binder resin is preferably one in which the binder resin is soluble, which is noncorrosive to the substrate to be coated with the conductive adhesive, and which has high boiling point and low volatility so that the dry hardiness can be improved for increased ease of printing procedure because the conductive adhesive is applied to the substrate by a method such as screen printing or stamping. Accordingly, in view of maintaining such properties, an organic solvent such as butyl carbitol, butyl carbitol acetate, carbitol acetate, terpineol, or diethyl phthalate is preferably used. Several types of such solvents can also be used in combination.

In addition, the content of the solvent in the overall conductive adhesive is preferably 30% by mass or less. If the content of the solvent exceeds 30% by mass, the conductive adhesive may, for example, slump during screen printing because of its excessively low viscosity, thus degrading the coating properties of the conductive adhesive and the ease of printing procedure, and also adversely affects other members because it outgases considerably during drying.

In addition to the components described above, the conductive adhesive of the present invention may further contain additives such as a curing promoter, a silane coupling agent, a flame retardant, a thickening agent, a thixotropic agent, a leveling agent, and a plasticizing agent. For example, a plasticizing agent can be added to improve the dry hardiness, which is an important characteristic in continuous printing by, for example, screen printing or stamping. Examples of preferred plasticizing agents include phthalic acid derivatives, isophthalic acid derivatives, tetrahydrophthalic acid derivatives, adipic acid derivatives, maleic acid derivatives, fumaric acid derivatives, trimellitic acid derivatives, pyromellitic acid derivatives, stearic acid derivatives, oleic acid derivatives, itaconic acid derivatives, ricinolic acid derivatives, and hydrogenated castor oil and derivatives thereof.

The conductive adhesive of the present invention is characterized in that the conductive filler contains ultrafine metal particles having an average particle size of 100 nm or less. In this case, the ultrafine metal particles having a particle size of 100 nm or less fill gaps in the metal powder used as the conductive filler and having relatively large particle size to increase the packing density of the metal in the conductive filler, thus improving the conductive properties at low sintering temperature (200°C or less). In addition, the ultrafine metal particles having an average particle size of 100 nm or less sinter at low temperature (200°C or less) to form a metallic bond with the metal substrate to be bonded. Thus, the adhesion properties of the conductive adhesive can be improved.

The ultrafine metal particles used may be ultrafine particles of silver, copper, gold, platinum, palladium, iridium, rhodium, ruthenium, nickel, tin, or zinc. Of these, silver ultrafine particles are preferably used in view of conductive properties, oxidation resistance, and cost.

In addition, the average particle size of the ultrafine metal particles is 100 nm or less. If the average particle size exceeds 100 nm, the conductive properties can be improved, although it is difficult to form a metallic bond with the metal substrate and, consequently, the adhesion properties may be insufficiently improved.

In addition, if the conductive filler used is a mixture of a metal powder having relatively large particle size and ultrafine metal particles having an average particle size of 100 nm or less in a predetermined mixing ratio, the content of the ultrafine metal particles in the overall conductive filler (that is, based on 100% by mass of the overall conductive filler) is preferably 0.1 % to 10% by mass. If the content of the ultrafine metal particles falls below 0.1 % by mass, the ultrafine metal particles do not sufficiently provide the above-described effect of improving the conductive properties and the adhesion properties. On the other hand, if the content of the ultrafine metal particles exceeds 10% by mass, the proportion of the ultrafine metal particles is high relative to that of the squamiform filler, and consequently the contact between the squamiform filler particles is decreased, thus degrading the conductive properties. In addition, the cost is increased because the amount of ultrafine metal particles used is increased.

The conductive adhesive is prepared by, for example, dissolving a binder resin such as an epoxy resin in a solvent such as butyl carbitol acetate, adding a metal powder and ultrafine metal particles as the conductive filler, adding and mixing a latent curing agent and other additives, and kneading the mixture using a three-roll.

In addition, as described above, the conductive adhesive of the present invention has the superior property of providing improved conductive properties and adhesion properties. Thus, the conductive adhesive of the present invention is suitable for use as an adhesive for bonding an LED device to a metal substrate to form an LED substrate including the metal substrate and the LED device bonded to the metal substrate.

The embodiment described above provides the following advantages:
(1) In this embodiment, the conductive filler contains a metal powder having an average particle size of 2 to 30 µm as its main component and also contains ultrafine metal particles having an average particle size of 100 nm or less. Thus, the ultrafine metal particles having a particle size of 100 nm or less fill gaps in the metal powder used as the conductive filler and having relatively large particle size to increase the packing density of the metal in the conductive filler, thus improving the conductive properties of the conductive adhesive at low sintering temperature (200°C or less). In addition, the ultrafine metal particles having an average particle size of 100 nm or less sinter at low temperature (200°C or less) to form a metallic bond with the metal substrate to be bonded. Thus, the adhesion properties of the conductive adhesive can be improved.

(2) In this embodiment, the content of the ultrafine metal particles in the overall conductive filler is set to 0.1 % to 10% by mass. Thus, the ultrafine metal particles sufficiently provide the effect of improving the conductive properties and the adhesion properties without a substantial cost increase.

(3) In this embodiment, the content of the conductive filler in the overall conductive adhesive is set to 50% to 90% by mass. Thus, the conductive properties and adhesion properties of the conductive adhesive can be reliably improved.

(4) In this embodiment, the metal powder used is silver powder. Because silver powder has low specific resistance, a conductive adhesive having superior conductive properties can be provided. In addition, a low-cost, oxidation-resistant conductive adhesive can be provided.

### EXAMPLES

Examples of the present invention and comparative examples will now be described. The present invention is not limited to these examples; modifications and variations of the examples are permitted on the basis of the spirit of the present invention and are not excluded from the scope of the present invention.

### EXAMPLES 1 TO 6 AND COMPARATIVE EXAMPLES 1 AND 2

Silver powder (the trade name AgC-L, manufactured by Fukuda Metal Foil & Powder Co., Ltd.) or copper powder (the trade name MA-CJF, manufactured by Mitsui Mining & Smelting Co., Ltd.), silver ultrafine particles (the trade name AGIN-W4A, manufactured by Sumitomo Electric Industries, Ltd.), epoxy resins (the trade name EPICRON 830, manufactured by DIC Corporation (referred to as "epoxy resin 1" in Table I), and the trade name YDCN-704, manufactured by Tohto Kasei Co., Ltd. (referred to as "epoxy resin 2" in Table I)), and dicyandiamide (the trade name DICY7, manufactured by Japan Epoxy Resins Co., Ltd.), serving as a curing agent for epoxy resins, of the types shown in Table I were mixed in the amounts shown in Table I using a rotary agitating deaerator and, after the mixtures were determined to be homogeneous by observation, were kneaded using a three-roll. Butyl carbitol acetate was then added in the amounts shown in Table I, thus preparing conductive adhesives of Examples 1 to 6 and Comparative Examples 1 and 2. The prepared conductive adhesives had no abnormal appearance in an ordinary state.

### Volume Resistivity Evaluation

Next, the prepared conductive adhesives of Examples 1 to 6 and Comparative Examples 1 and 2 were applied to polyimide substrates (the trade name Kapton, manufactured by Du Pont-Toray Co., Ltd.) using a doctor blade to form films having a width of 50 mm and a length of 80 mm, were dried, were placed in a constant-temperature chamber, and were heated and cured at the temperatures shown in Table I for the periods of time shown in Table I, thus forming conductive films. The volume resistivities of the conductive films were then measured using a resistivity meter (the trade name Loresta, manufactured by Dia Instruments Co., Ltd.). The results are shown in Table I. As the evaluation criterion, a volume resistivity of 900 µΩ·cm was used as the reference value, and the conductive films were determined to be satisfactory in conductive properties if the volume resistivity was lower than the reference value and were determined to be unsatisfactory in conductive properties if the volume resistivity was not lower than the reference value.

### Adhesion Properties Evaluation

Next, after the stage temperature was set to room temperature and the prepared conductive adhesives of Examples 1 to 6 and Comparative Examples 1 and 2 were applied to 2 cm square metal substrates (silver-plated copper substrates) by stamping, 3 mm square silicon chips were placed on the conductive adhesives and were bonded to the metal substrates with the conductive adhesives therebetween by curing the conductive adhesives under the curing conditions shown in Table I. Subsequently, the strengths at which the silicon chips peeled as force was applied in the horizontal direction were determined using Bondtester (the trade name Series 400, manufactured by Dage Arctek Co., Ltd.). The results are shown in Table I. As the evaluation criterion, an adhesion strength of 15 N/mm² was used as the reference value, and the conductive adhesives were determined to be satisfactory in adhesion properties if the adhesion strength was not lower than the reference value and were determined to be unsatisfactory in adhesion properties if the adhesion strength was lower than the reference value. In addition, the adhesion strength in the case where the stage temperature was set to 150°C was similarly measured. As the evaluation criterion, an adhesion strength of 10 N/mm² was used as the reference value, and the conductive adhesives were determined to be satisfactory in adhesion properties if the adhesion strength was not lower than the reference value and were determined to be unsatisfactory in adhesion properties if the adhesion strength was lower than the reference value. The results are shown in Table I.

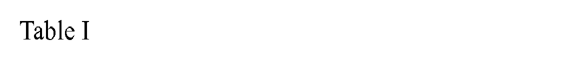

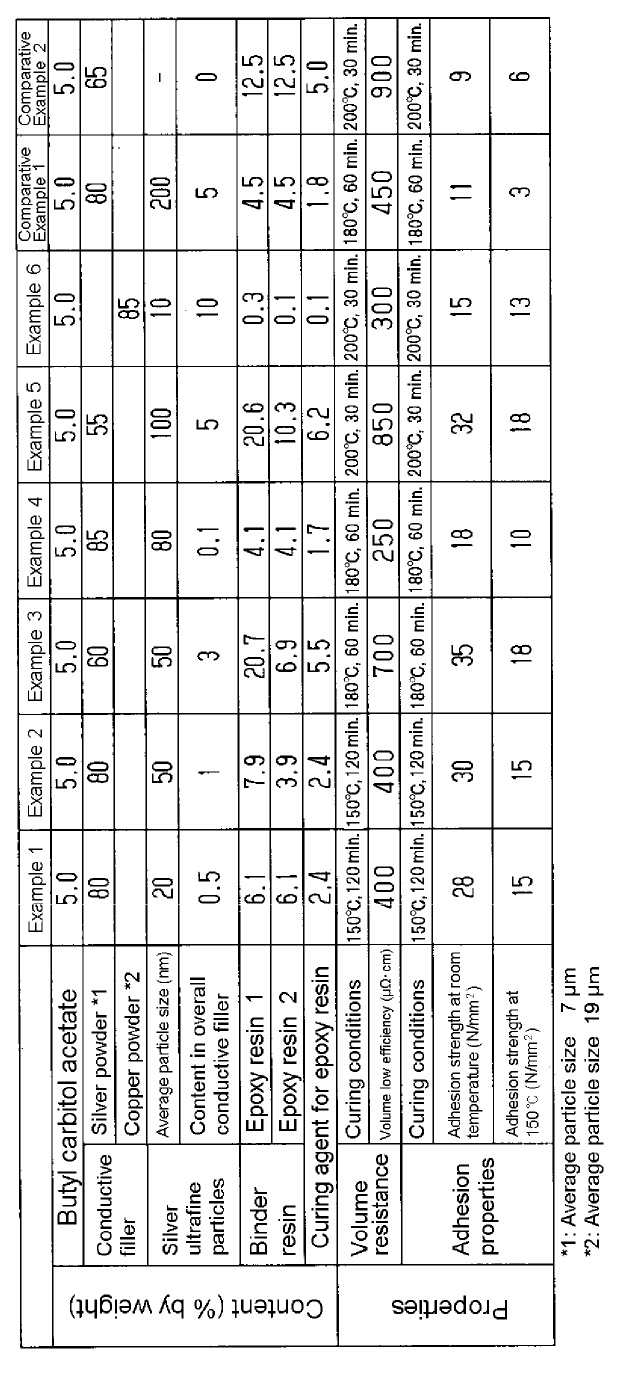

As shown in Table I, the conductive adhesives of Examples 1 to 6 and Comparative Example 1 had volume resistance lower than the reference value for evaluation, namely, 900 µΩ·cm, thus having satisfactory conductive properties. On the other hand, the conductive adhesive of Comparative Example 2 had a volume resistance not lower than the reference value for evaluation, namely, 900 µΩ·cm, thus having unsatisfactory conductive properties. This is because, for the conductive adhesive of Comparative Example 2, the conductive filler contained no ultrafine metal particles.

As shown in Table I, additionally, the conductive adhesives of Examples 1 to 6 had adhesion strengths not lower than the reference values for evaluation, namely, 15 N/mm² and 10 N/mm², thus having satisfactory adhesion properties. On the other hand, the conductive adhesives of Comparative Examples 1 and 2 had adhesion strengths lower than the reference values for evaluation, namely, 15 N/mm² and 10 N/mm², thus having unsatisfactory adhesion properties. This is because, for the conductive adhesive of Comparative Example 1, the ultrafine metal particles contained in the conductive filler did not form a metallic bond with the metal substrate to be bonded because they had a large average particle size, namely, 200 nm, and for the conductive adhesive of Comparative Example 2, the conductive filler contained no ultrafine metal particles.

### Industrial Applicability

An example of application of the present invention is conductive adhesives used for bonding, for example, semiconductor devices and chip parts.

## Claims

1. A conductive adhesive comprising a conductive filler, a binder resin, and a solvent as main components thereof, wherein the conductive filler contains a metal powder having an average particle size of 2 to 30 µm as a main component thereof and contains ultrafine metal particles having an average particle size of 100 nm or less.

2. The conductive adhesive according to Claim 1, wherein the content of the ultrafine metal particles in the overall conductive filler is 0.1 % to 10% by mass.

3. The conductive adhesive according to Claim 1 or 2, wherein the content of the conductive filler in the overall conductive adhesive is 50% to 90% by mass.

4. The conductive adhesive according to one of Claims 1 to 3, wherein the metal powder is silver powder.

5. An LED substrate comprising a metal substrate and an LED device, wherein the metal substrate and the LED device are bonded with the conductive adhesive according to one of Claims 1 to 4.
